# EUROPEAN PATENT APPLICATION

(11) **EP 4 707 988 A1**
(43) Date of publication of application: **11.03.2026**
(21) Application number: 24843294.0
(22) Date of filing: 29.05.2024
(51) Int. Cl.: G06F 1/16, B32B 17/02

(54) **ELECTRONIC DEVICE COMPRISING WING PLATE, AND MANUFACTURING METHOD OF WING PLATE**

(30) Priority: 20.07.2023 KR 20230094468; 21.08.2023 KR 20230108968
(71) Applicant: Samsung Electronics Co., Ltd., Suwon-si, Gyeonggi-do 16677 (KR)
(72) Inventor: JANG, Jigu, Suwon-si Gyeonggi-do 16677 (KR); LEE, Kwangyoun, Suwon-si Gyeonggi-do 16677 (KR); LEE, Jeongwon, Suwon-si Gyeonggi-do 16677 (KR)
(74) Representative: Gulde & Partner
(86) International application number: PCT/KR2024/007322
(87) International publication number: WO 2025/018573

(57) **Abstract**

This electronic device may comprise: a display assembly including a first area, a second area and a folding area between the first area and the second area; a first housing for supporting the first area; a second housing for supporting the second area; a hinge unit connecting the first housing to the second housing, and operating between a folded state in which the first area and the second area face each other and an unfolded state in which the first area and the second area do not face each other; and a wing plate which is disposed between the hinge unit and the display assembly and which supports the display assembly. The wing plate can be formed by laminating a plurality of sheets.

## Description

### TECHNICAL FIELD

The present disclosure relates to an electronic device including a wing plate and a manufacturing method of the wing plate.

### BACKGROUND ART

With the development of display-related technologies, electronic devices including flexible displays have recently been developed. A flexible display may be used in a flat form and may also be deformed into a particular shape for use. For example, an electronic device including a flexible display may be implemented in a foldable form which may be folded or unfolded with respect to at least one folding axis.

However, the foregoing should not be construed as having been acknowledged by the applicant as a prior art to the description set forth in the disclosure but should be construed only as a related art to the invention described herein.

### DISCLOSURE OF THE INVENTION

According to an embodiment of the present disclosure, an electronic device includes a display assembly including a first area, a second area, and a folding area between the first area and the second area, a first housing supporting the first area, a second housing supporting the second area, a hinge unit connecting the first housing and the second housing and operating between a folded state in which the first area and the second area face each other and an unfolded state in which the first area and the second area do not face each other, and a wing plate disposed between the hinge unit and the display assembly and supporting the display assembly. In an embodiment, the wing plate is formed by laminating a plurality of sheets.

In addition, according to an embodiment of the present disclosure, a manufacturing method of a wing plate includes laminating a plurality of sheets, positioning the plurality of sheets in a mold and thermoforming the plurality of sheets, cutting the thermoformed plurality of sheets to form the wing plate, and washing the wing plate.

### BRIEF DESCRIPTION OF DRAWINGS

FIG. 1 is a block diagram illustrating an electronic device in a network environment according to an embodiment.
FIG. 2A is a diagram illustrating an unfolded state of an electronic device according to an embodiment of the present disclosure.
FIG. 2B is a diagram illustrating a folded state of the electronic device according to an embodiment of the present disclosure.
FIG. 2C is a perspective view illustrating a fully unfolded state of the electronic device according to an embodiment of the present disclosure.
FIG. 2D is a perspective view illustrating an example of a partially unfolded intermediate state of the electronic device according to embodiments of the present disclosure.
FIG. 3A is an exploded perspective view of an electronic device according to an embodiment.
FIG. 3B is a plan view of a portion of the electronic device according to an embodiment.
FIG. 3C is a cross-sectional view of the electronic device according to an embodiment.
FIG. 4A is an exploded perspective view of a plurality of sheets according to an embodiment.
FIG. 4B is a plan view of the plurality of sheets according to an embodiment.
FIG. 5A is a perspective view of a wing plate according to an embodiment.
FIG. 5B is a plan view of the wing plate according to an embodiment.
FIG. 5C is a rear view of the wing plate according to an embodiment.
FIG. 6A is a cross-sectional view of a portion of the wing plate according to an embodiment.
FIG. 6B is a cross-sectional view of a portion of the wing plate according to an embodiment.
FIG. 6C is a cross-sectional view of a portion of the wing plate according to an embodiment.
FIG. 7 is a cross-sectional view of a portion of the wing plate according to an embodiment.
FIG. 8A is a perspective view of the wing plate according to an embodiment.
FIG. 8B is a perspective view of the wing plate and a coupling member according to an embodiment.
FIG. 8C is an exploded perspective view of the wing plate and the coupling member according to an embodiment.
FIG. 9 is a flowchart of a manufacturing method of the wing plate according to an embodiment.
FIG. 10 is a flowchart of the manufacturing method of the wing plate according to an embodiment.

### BEST MODE FOR CARRYING OUT THE INVENTION

Hereinafter, the examples will be described in detail with reference to the accompanying drawings. When describing the examples with reference to the accompanying drawings, like reference numerals refer to like components and a repeated description related thereto will be omitted.

The electronic device according to an embodiment may be one of various types of electronic devices. The electronic devices may include, for example, a portable communication device (e.g., a smart phone), a computer device, a portable multimedia device, a portable medical device, a camera, a wearable device, or a home appliance. According to an embodiment of the disclosure, the electronic device is not limited to those described above.

It should be appreciated that an embodiment of the disclosure and the terms used therein are not intended to limit the technological features set forth herein to particular embodiments and include various changes, equivalents, or replacements for a corresponding embodiment. In connection with the description of the drawings, like reference numerals may be used for similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "A, B, or C," each of which may include any one of the items listed together in the corresponding one of the phrases, or all possible combinations thereof. Terms such as "first", "second", or "first" or "second" may simply be used to distinguish the component from other components in question, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., by wire), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

An embodiment as set forth herein may be implemented as software (e.g., the program 140) including one or more instructions which are stored in a storage medium (e.g., internal memory 136 or external memory 138) which is readable by a machine (e.g., the electronic device 101). For example, a processor (e.g., the processor 120) of the machine (e.g., the electronic device 101) may invoke at least one of the one or more instructions stored in the storage medium and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment disclosed herein may be included and provided in a computer program product. The computer program product may be traded as a product between a seller and a buyer. The computer program product may be distributed in the form of a machine-readable storage medium (e.g., a compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as a memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

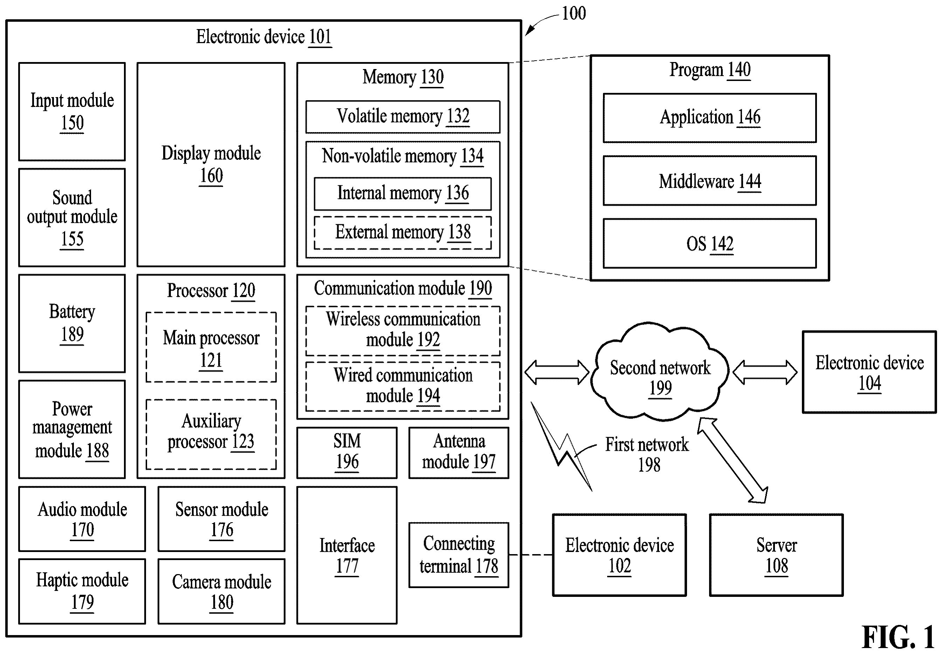

FIG. 1 is a block diagram illustrating an electronic device 101 in a network environment 100 according to an embodiment.

Referring to FIG. 1, the electronic device 101 in the network environment 100 may communicate with an electronic device 102 via a first network 198 (e.g., a short-range wireless communication network) or may communicate with an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, and a sensor module 176, an interface 177, a connecting terminal 178, a haptic module 179, a camera module 180, a power management module 188, a battery 189, a communication module 190, a subscriber identification module (SIM) 196, or an antenna module 197. In some examples, at least one (e.g., the connecting terminal 178) of the above components may be omitted from the electronic device 101, or one or more other components may be added to the electronic device 101. In some examples, some (e.g., the sensor module 176, the camera module 180, or the antenna module 197) of the components may be integrated as a single component (e.g., the display module 160).

The processor 120 may execute, for example, software (e.g., a program 140) to control at least one other component (e.g., a hardware or software component) of the electronic device 101 connected to the processor 120 and may perform various data processing or computation. According to an embodiment, as at least a part of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) which is operable independently of, or in conjunction with the main processor 121. For example, when the electronic device 101 includes the main processor 121 and the auxiliary processor 123, the auxiliary processor 123 may be adapted to consume less power than the main processor 121 or to be dedicated to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101 instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as part of another component (e.g., the camera module 180 or the communication module 190) functionally related to the auxiliary processor 123. According to an embodiment, the auxiliary processor 123 (e.g., an NPU) may include a hardware structure specified for artificial intelligence (AI) model processing. An AI model may be generated by machine learning. Such learning may be performed by, for example, the electronic device 101 in which AI is performed or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but examples are not limited thereto. The AI model may additionally or alternatively include a software structure other than the hardware structure.

The memory 130 may store various pieces of data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive, from outside (e.g., a user) the electronic device 101, a command or data to be used by another component (e.g., the processor 120) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a recording. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a control circuit for controlling a display, a hologram device, or a projector and control circuitry to control a corresponding one of the display, the hologram device, and the projector. According to an embodiment, the display device 160 may include a touch sensor adapted to sense a touch or a pressure sensor adapted to measure the intensity of a force incurred by the touch.

The audio module 170 may convert a sound into an electric signal or vice versa. According to an embodiment, the audio module 170 may obtain the sound via the input module 150 or may output the sound via an external electronic device (e.g., an electronic device 102) (e.g., a speaker or headphone) directly or wirelessly connected to the electronic device 101.

The sensor module 176 may detect an operational state (e.g., power or temperature) of the electronic device 101 or an environmental state (e.g., a state of a user) external to the electronic device 101 and may generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used by the electronic device 101 to couple with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electric signal into a mechanical stimulus (e.g., a vibration or a movement) or an electrical stimulus, which may be recognized by a user via their tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs which are operable independently from the processor 120 (e.g., an AP) and that support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or IR data association (IrDA)) or the second network 199 (e.g., a long-range communication network, such as a legacy cellular network, a 5G network, a next-generation communication network, the Internet, or a computer network (e.g., a LAN or a wide area network (WAN)). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, by using subscriber information (e.g., international mobile subscriber identity (IMSI)) stored in the SIM 196.

The wireless communication module 192 may support a 5G network after a 4G network, and next-generation communication technology, for example, new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, for example, a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beamforming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., an external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or the power may be transmitted or received between the communication module 190 and the external electronic device via the at least one selected antenna. According to an embodiment, another component (e.g., a radio frequency integrated circuit (RFIC)) other than the radiating element may be additionally formed as a portion of the antenna module 197.

According to an embodiment, the antenna module 197 may form a mmWave antenna module. According to an embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of the same type as or a different type from the electronic device 101. According to an embodiment, all or some of operations to be executed by the electronic device 101 may be executed at one or more external electronic devices (e.g., the external devices 102 and 104, and the server 108). For example, if the electronic device 101 needs to perform a function or a service automatically, or in response to a request from a user or another device, the electronic device 101, instead of, or in addition to, executing the function or the service, may request the one or more external electronic devices to perform at least part of the function or service. The one or more external electronic devices receiving the request may perform the at least part of the function or service, or an additional function or an additional service related to the request and may transfer a result of the performance to the electronic device 101. The electronic device 101 may provide the result, with or without further processing the result, as at least part of a response to the request. To that end, cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an Internet-of-Things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

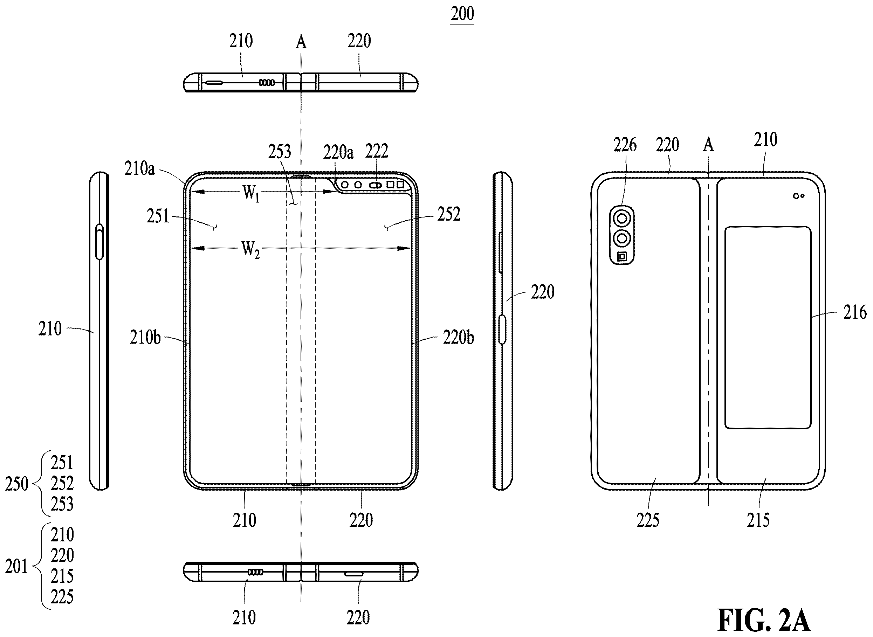

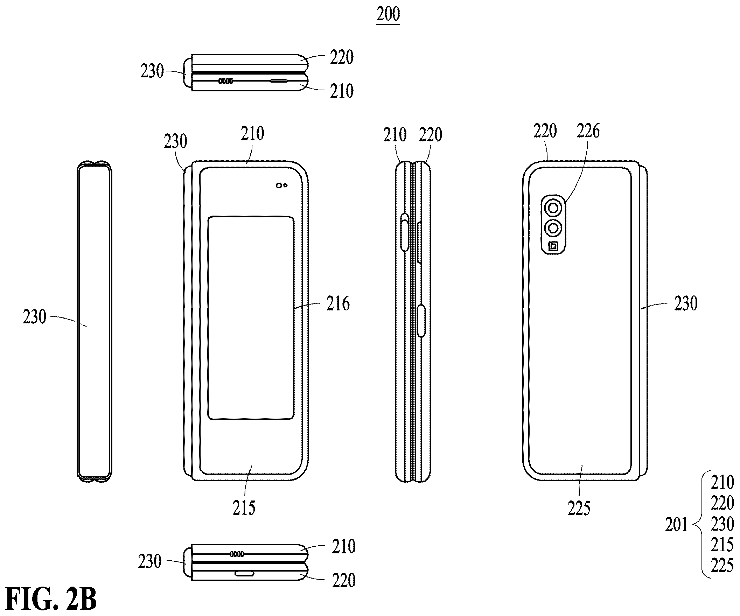

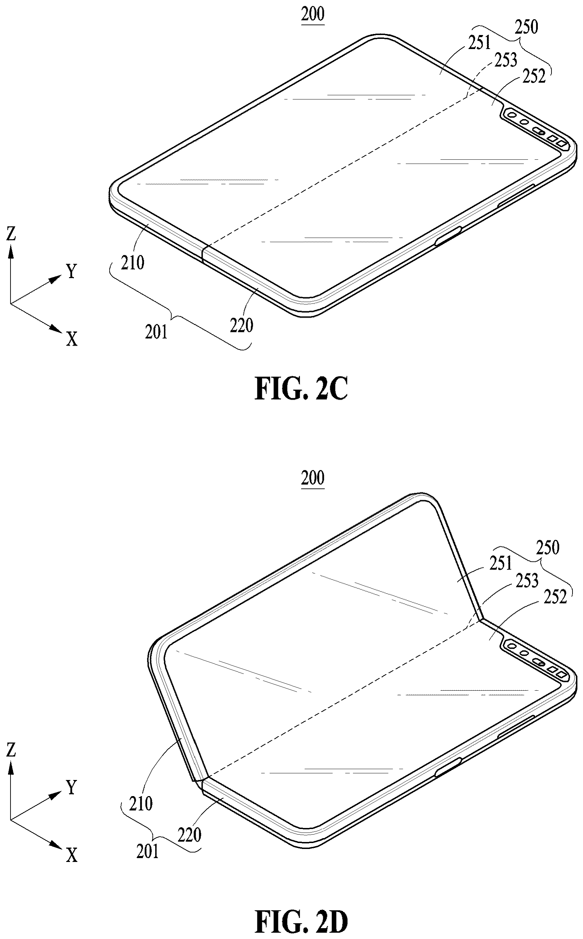

FIG. 2A is a diagram illustrating an unfolded state of an electronic device 200 according to an embodiment of the present disclosure, FIG. 2B is a diagram illustrating a folded state of the electronic device 200 according to an embodiment of the present disclosure, FIG. 2C is a perspective view illustrating a fully unfolded state of the electronic device 200 according to an embodiment of the present disclosure, and FIG. 2D is a perspective view illustrating an example of a partially unfolded intermediate state of the electronic device 200 according to embodiments of the present disclosure.

The electronic device 200 of FIGS. 2A to 2D is an example of the electronic device 101 of FIG. 1 and may be a foldable or bendable electronic device.

In FIG. 2C and the following drawings, illustrated is a spatial coordinate system defined by an X-axis, a Y-axis, and a Z-axis which are orthogonal to each other. Here, the X-axis may represent a width direction of an electronic device, the Y-axis may represent a length direction of the electronic device, and the Z-axis may represent a height (or thickness) direction of the electronic device. In the following description, a "first direction" may refer to a direction parallel to the Z-axis.

Referring to FIGS. 2A and 2B, in an embodiment, the electronic device 200 may include a foldable housing 201, and a flexible or foldable display 250 (hereinafter, the "display" 250 in short) (e.g., the display module 160 of FIG. 1) in a space formed by the foldable housing 201.

A surface on which the display 250 is disposed (or a surface from which the display 250 is viewed from outside the electronic device 200) may be defined as a front surface of the electronic device 200. In addition, a surface opposite to the front surface may be defined as a rear surface of the electronic device 200. In addition, a surface surrounding a space between the front surface and the rear surface may be defined as a side surface of the electronic device 200.

According to an embodiment, the foldable housing 201 may include a first housing structure 210, a second housing structure 220 including a sensor area 222, a first rear cover 215, a second rear cover 225, and a hinge structure 230. Here, the hinge structure 230 may include a hinge cover which covers a foldable portion of the foldable housing 201. The foldable housing 201 of the electronic device 200 is not limited to the shape and combination illustrated in FIGS. 2A and 2B and may be implemented in a different shape or a different combination of components. For example, in an embodiment, the first housing structure 210 and the first rear cover 215 may be integrally formed, and the second housing structure 220 and the second rear cover 225 may be integrally formed.

According to an embodiment, the first housing structure 210 may be connected to the hinge structure 230 and may include a first surface facing a first direction and a second surface facing a second direction opposite to the first direction. The second housing structure 220 may be connected to the hinge structure 230 and may include a third surface facing a third direction and a fourth surface facing a fourth direction opposite the third direction. The second housing structure 220 may rotate with respect to the first housing structure 210 based on the hinge structure 230. A state of the electronic device 200 may be changed to a folded state or an unfolded state.

According to an embodiment, the first surface may face the third surface in a state in which the electronic device 200 is fully folded, and the third direction may be identical to the first direction in the fully unfolded state of the electronic device 200.

According to an embodiment, the first housing structure 210 and the second housing structure 220 are disposed on both sides with respect to a folding axis A and generally may be symmetrical with respect to the folding axis A. As will be described hereinafter, an angle or distance between the first housing structure 210 and the second housing structure 220 may vary depending on whether the electronic device 200 is in the unfolded state, the folded state, or an intermediate state (e.g., a partially folded state or a partially unfolded state). According to an embodiment, unlike the first housing structure 210, the second housing structure 220 may additionally include the sensor area 222, in which various sensors are arranged, however, the first housing structure 210 and the second housing structure 220 may have mutually symmetrical shapes in areas other than the sensor area 222.

According to an embodiment, as shown in FIG. 2A, the first housing structure 210 and the second housing structure 220 may together form a recess for accommodating the display 250.

According to an embodiment, due to the sensor area 222, the recess may have at least two different widths in a direction perpendicular to the folding axis A. For example, the recess may have a first width W₁ between a first portion 210a of the first housing structure 210 parallel to the folding axis A and a first portion 220a of the second housing structure 220 formed on a periphery of the sensor area 222, and a second width W₂ formed by a second portion 210b of the first housing structure 210 and a second portion 220b of the second housing structure 220 not corresponding to the sensor area 222 and being parallel to the folding axis A. In this example, the second width W₂ may be greater than the first width W₁. In an embodiment, the first portion 220a and the second portion 220b of the second housing structure 220 may be at different distances from the folding axis A. The widths of the recess are not limited to the shown example.

In an embodiment, the recess may have a plurality of widths according to the shape of the sensor area 222 or asymmetrical portions of the first housing structure 210 and the second housing structure 220. In an embodiment, the sensor area 222 may be formed to have a predetermined area adjacent to one corner of the second housing structure 220. However, the arrangement, shape, and size of the sensor area 222 are not limited to the shown example. For example, in an embodiment, the sensor area 222 may be provided at another corner of the second housing structure 220 or in a predetermined area between an upper corner and a lower corner.

In an embodiment, components embedded in the electronic device 200 to perform various functions may be exposed to the front surface of the electronic device 200 through the sensor area 222 or through one or more openings provided in the sensor area 222. In an embodiment, the components may include various types of sensors. The sensors may include, for example, at least one of a front camera, a receiver, or a proximity sensor. According to an embodiment, the sensor area 222 may not be included in the second housing structure 220 or may be formed at a position different from that shown in the drawings.

According to an embodiment, at least a portion of the first housing structure 210 and the second housing structure 220 may be formed of a metal material or a non-metal material having a selected magnitude of rigidity to support the display 250. At least a portion of the first housing structure 210 and the second housing structure 220 formed of the metal material may provide a ground plane for the electronic device 200 and may be electrically connected to a ground line formed on a PCB in the foldable housing 201.

According to an embodiment, the first rear cover 215 may be on one side of the folding axis A on the rear surface of the electronic device 200 and may have, for example, a substantially rectangular periphery which may be enclosed by the first housing structure 210. Similarly, the second rear cover 225 may be on another side of the folding axis A on the rear surface of the electronic device 200 and may have a periphery which may be enclosed by the second housing structure 220.

According to an embodiment, the first rear cover 215 may be substantially symmetrical to the second rear cover 225 with respect to the folding axis A. However, the first rear cover 215 and the second rear cover 225 do not necessarily have mutually symmetrical shapes. For example, the electronic device 200 may include the first rear cover 215 and the second rear cover 225 in various shapes. In an embodiment, the first rear cover 215 may be formed integrally with the first housing structure 210, and the second rear cover 225 may be formed integrally with the second housing structure 220.

According to an embodiment, the first rear cover 215, the second rear cover 225, the first housing structure 210, and the second housing structure 220 may form a space in which various components (e.g., a printed circuit board (PCB), or a battery) of the electronic device 200 are to be disposed. In an embodiment, one or more components may be disposed or visually exposed on the rear surface of the electronic device 200. For example, at least a portion of a sub-display may be visually exposed through a first rear area 216 of the first rear cover 215. In an embodiment, one or more components or sensors may be visually exposed through a second rear area 226 of the second rear cover 225. In an embodiment, the sensors may include a proximity sensor and/or a rear camera.

According to an embodiment, a front camera exposed to the front surface of the electronic device 200 through one or more openings provided in the sensor area 222, or a rear camera exposed through the second rear area 226 of the second rear cover 225 may include one or more lenses, an image sensor, and/or an ISP. A flash may include, for example, a light-emitting diode (LED) or a xenon lamp. In an embodiment, two or more lenses (e.g., infrared (IR) camera, wide-angle, and telephoto lenses) and image sensors may be arranged on one surface of the electronic device 200.

Referring to FIG. 2B, the hinge cover may be between the first housing structure 210 and the second housing structure 220 to cover internal components (e.g., the hinge structure 230). According to an embodiment, the hinge structure 230 may be covered by a portion of the first housing structure 210 and a portion of the second housing structure 220 or may be exposed to the outside depending on a state (e.g., the unfolded state, the intermediate state, or the folded state) of the electronic device 200.

For example, when the electronic device 200 is in the unfolded state (e.g., the fully unfolded state) as illustrated in FIG. 2A, the hinge structure 230 may be covered by the first housing structure 210 and the second housing structure 220 and may not be exposed. For another example, when the electronic device 200 is in the folded state (e.g., a fully folded state), as illustrated in FIG. 2B, the hinge structure 230 may be exposed to the outside between the first housing structure 210 and the second housing structure 220. For another example, when the first housing structure 210 and the second housing structure 220 are in the intermediate state of being folded at a predetermined angle, at least a portion of the hinge structure 230 may be exposed to the outside between the first housing structure 210 and the second housing structure 220. In this case, the exposed area may be less than an area exposed in the fully folded state. In an embodiment, the hinge structure 230 may have a curved surface.

According to an embodiment, the display 250 may be disposed in a space formed by the foldable housing 201. For example, the display 250 may be seated in the recess formed by the foldable housing 201 and may be viewed from the outside through the front surface of the electronic device 200. For example, the display 250 may form most of the front surface of the electronic device 200. Accordingly, the front surface of the electronic device 200 may include the display 250 and a partial area of the first housing structure 210 and a partial area of the second housing structure 220, which are adjacent to the display 250. In addition, the rear surface of the electronic device 200 may include the first rear cover 215, a partial area of the first housing structure 210 adjacent to the first rear cover 215, the second rear cover 225, and a partial area of the second housing structure 220 adjacent to the second rear cover 225.

In an embodiment, the display 250 may refer to a display in which at least one area is deformable into a planar surface or a curved surface. According to an embodiment, the display 250 may include a folding area 253, a first area 251 which is on one side of the folding area 253 (e.g., on the left side of the folding area 253 illustrated in FIG. 2A), and a second area 252 which is on the other side of the folding area 253 (e.g., on the right side of the folding area 253 illustrated in FIG. 2A).

However, such area division of the display 250 as illustrated in FIG. 2A is merely illustrative, and the display 250 may be divided into a plurality of areas (e.g., four or more areas or two areas) depending on a structure or functions thereof. For example, as illustrated in FIG. 2A, the display 250 may be divided into areas based on the folding area 253 extending in parallel to the folding axis A. For another example, the display 250 may be divided into areas based on another folding axis (e.g., a folding axis parallel to a width direction of an electronic device).

According to an embodiment, the display 250 may be coupled to or disposed adjacent to a touch panel including a touch sensing circuit and a pressure sensor for measuring a strength (a pressure) of a touch. For example, the display 250 may be coupled to or adjacent to a touch panel for detecting a stylus pen of an electromagnetic resonance (EMR) type, as an example of the touch panel.

According to an embodiment, the first area 251 and the second area 252 may have globally symmetrical shapes around the folding area 253. However, unlike the first area 251, the second area 252 may include a notch which is cut depending on a presence of the sensor area 222 but may have a shape symmetrical to the first area 251 in the other areas. For example, the first area 251 and the second area 252 may include portions having mutually symmetrical shapes and portions having mutually asymmetrical shapes.

According to an embodiment, the edge thickness of each of the first area 251 and the second area 252 may be different from the edge thickness of the folding area 253. The edge thickness of the folding area 253 may be less than those of the first area 251 and the second area 252. For example, the first area 251 and the second area 252 may be asymmetrical in terms of thickness when cross-sectionally viewed. For example, an edge of the first area 251 may have a first radius of curvature, and an edge of the second area 252 may have a second radius of curvature different from the first radius of curvature. For another example, the first area 251 and the second area 252 may be symmetrical in terms of thickness when cross-sectionally viewed.

Hereinafter, each area of the display 250 and operations of the first housing structure 210 and the second housing structure 220 depending on the state (e.g., the folded state, the unfolded state, or the intermediate state) of the electronic device 200 are described.

According to an embodiment, when the electronic device 200 is in the unfolded state (e.g., FIG. 2A), the first housing structure 210 and the second housing structure 220 may face the same direction while forming an angle of 180 degrees. The surface of the first area 251 and the surface of the second area 252 of the display 250 may face the same direction (e.g., a front direction of an electronic device) while forming 180 degrees. The folding area 253 may form the same plane in conjunction with the first area 251 and the second area 252.

According to an embodiment, when the electronic device 200 is in the folded state (e.g., FIG. 2B), the first housing structure 210 and the second housing structure 220 may face each other. The surface of the first area 251 and the surface of the second area 252 of the display 250 may face each other while forming a narrow angle (e.g., between 0 degrees and 10 degrees). At least a portion of the folding area 253 may form a curved surface having a predetermined curvature.

According to an embodiment, when the electronic device 200 is in the intermediate state, the first housing structure 210 and the second housing structure 220 may form a predetermined angle therebetween. The surface of the first area 251 and the surface of the second area 252 of the display 250 may form an angle greater than that in the folded state and smaller than that in the unfolded state. At least a portion of the folding area 253 may include a curved surface having a predetermined curvature, and the curvature may be smaller than that in the folded state.

FIG. 2C illustrates a fully unfolded state of the electronic device 200, and FIG. 2D illustrates a partially unfolded intermediate state of the electronic device 200. As described above, the state of the electronic device 200 may be changed to the folded state or the unfolded state. According to an embodiment, when viewed in a direction of a folding axis (e.g., the folding axis A of FIG. 2A), the electronic device 200 may be folded in two types, i.e., an "in-folding" type in which the front surface of the electronic device 200 is folded to form an acute angle and an "out-folding" type in which the front surface of the electronic device 200 is folded to form an obtuse angle. For example, in the state in which the electronic device 200 is folded in the in-folding type, the first surface of the first housing structure 210 may face the third surface of the second housing structure 220. In the fully unfolded state, the first surface of the first housing structure 210 and the third surface of the second housing structure 220 may face the same direction (e.g., a direction parallel to the Z-axis).

For another example, when the electronic device 200 is folded in the out-folding type, the second surface of the first housing structure 210 may face the fourth surface of the second housing structure 220.

In addition, although not shown in the drawings, the electronic device 200 may include a plurality of hinge axes (e.g., two parallel hinge axes including the folding axis A of FIG. 2A and another axis parallel to the folding axis A). In this example, the electronic device 200 may also be folded in a "multi-folding" type in which the in-folding type and the out-folding type are combined.

The in-folding type may refer to a state in which the display 250 is not exposed to the outside in the fully folded state. The out-folding type may refer to a state in which the display 250 is exposed to the outside in the fully folded state.

Although the state in which the electronic device 200 is folded in the in-folding type is described below for convenience's sake, it should be noted that the description may be similarly applied in the state in which the electronic device 200 is folded in the out-folding type.

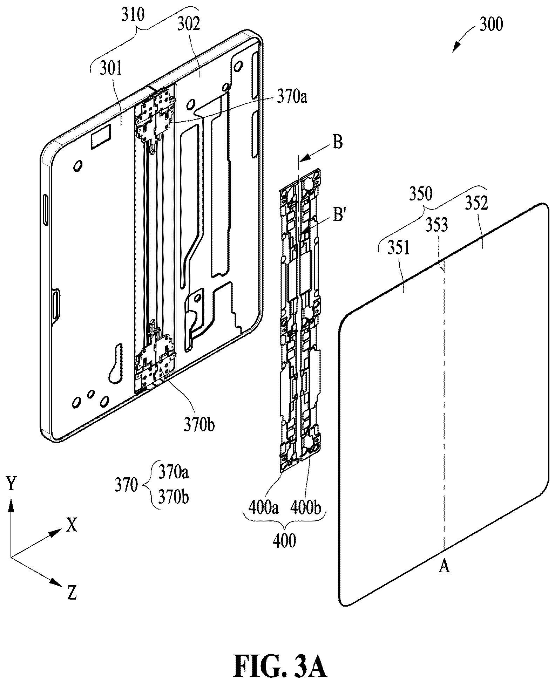

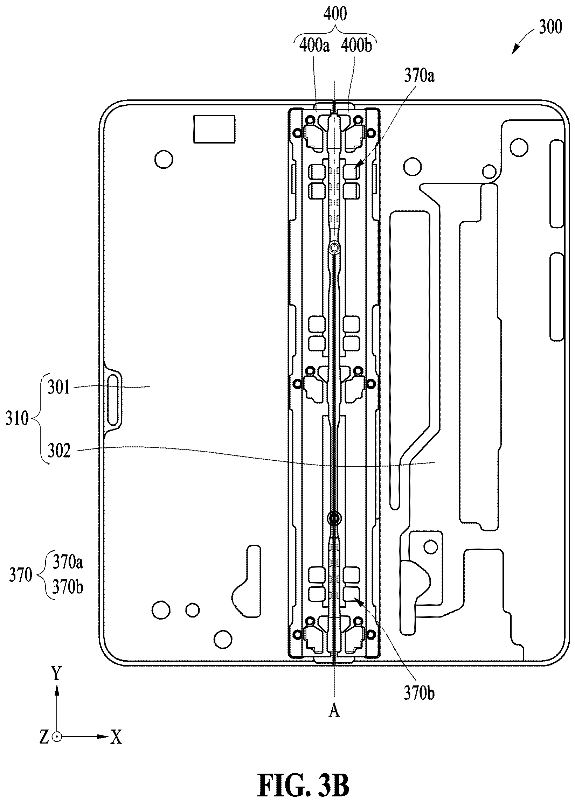

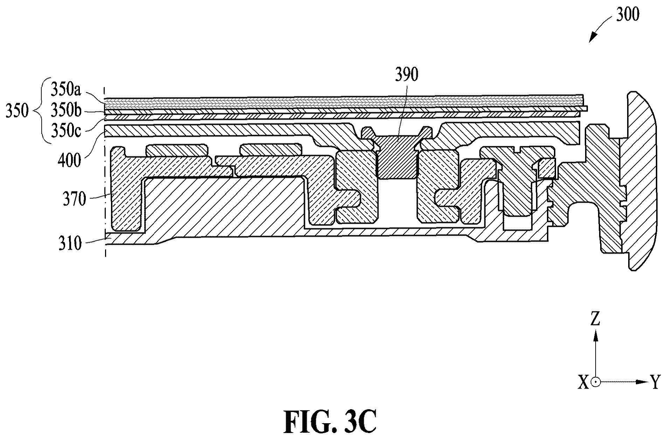

FIG. 3A is an exploded perspective view of an electronic device 300 according to an embodiment, FIG. 3B is a plan view of a portion of the electronic device 300 according to an embodiment, and FIG. 3C is a cross-sectional view of the electronic device 300 according to an embodiment.

Specifically, FIG. 3B is a plan view of a display assembly 350 in an exploded state in the electronic device 300 of FIG. 3A, and FIG. 3C is a cross-sectional view taken along line B-B' of FIG. 2B, illustrating an internal structure of the electronic device 300.

Referring to FIGS. 3A, 3B, and 3C, the electronic device 300 (e.g., the electronic device 101 of FIG. 1 or the electronic device 200 of FIGS. 2A, 2B, 2C, and 2D) according to an embodiment may be a foldable electronic device 300. For example, the electronic device 300 may be folded or unfolded with respect to the folding axis A.

However, the electronic device 300 of FIGS. 3A, 3B, and 3C is merely illustrative, and the size, shape, structure, and hinge axis of the electronic device 300 are not limited thereto. For example, although the electronic device 300 illustrated in the drawings includes the folding axis A in a long side direction (e.g., the Y-axis direction), the electronic device 300 according to an embodiment may include a folding axis in a short side direction (e.g., the X-axis direction).

Hereinafter, the description provided above is not repeated, and it is obvious that a portion of the configuration and structure of the electronic device 300 may be replaced, added, or omitted within a scope easily understandable by one of ordinary skill in the art with reference to the following drawings and descriptions. In addition, at least one component or feature of the embodiments described above may be coupled to the electronic device 300 unless this is technically and clearly infeasible.

In an embodiment, the electronic device 300 may include at least some of a foldable housing 310 (e.g., the foldable housing 201 of FIGS. 2A, 2B, 2C, and 2D), the display assembly 350 (e.g., the display module 160 of FIG. 1 or the display 250 of FIGS. 2A to 2D), a hinge unit 370, and a wing plate 400.

In an embodiment, the foldable housing 310 may form at least a portion of the exterior of the electronic device 300. The foldable housing 310 may include a first housing 301 (e.g., the first housing structure 210 of FIGS. 2A, 2B, 2C, and 2D) and a second housing 302 (e.g., the second housing structure 220 of FIGS. 2A, 2B, 2C, and 2D).

In an embodiment, the hinge unit 370 may be disposed between the first housing 301 and the second housing 302. The first housing 301 and the second housing 302 may be foldably connected to each other by the hinge unit 370.

In an embodiment, an angle or distance between the first housing 301 and the second housing 302 may vary depending on whether the electronic device 300 is in a flat or unfolded state, a folded state, or an intermediate state. For example, the intermediate state may include all states between the unfolded state and the folded state.

In an embodiment, the first housing 301 and the second housing 302 may provide a space in which the display assembly 350 is disposed. The display assembly 350 may be a foldable flexible display assembly 350.

In an embodiment, the display assembly 350 may include a plurality of layers 350a, 350b, and 350c. For example, the second layer 350b may be a display panel, and the first layer 350a and the third layer 350c may collectively refer to a plurality of components disposed on respective front and back surfaces of the display panel.

For example, the first layer 350a may include at least some of a protective film, a glass layer formed of foldable glass, and a polarizing layer (polarizer) such as a polarizing film. In addition, the third layer 350c may include at least some of a polymer layer formed of a polymeric material and a metal sheet layer or reinforcing layer to reinforce rigidity of the second layer 350b.

However, the plurality of layers 350a, 350b, and 350c schematically illustrate some components of the display assembly 350. The actual implementation of the display assembly 350 is not limited thereto, and the display assembly 350 may further include various components and additional layers.

For example, the display assembly 350 may include a first area 351 (e.g., first area 251 of FIG. 2C), a second area 352 (e.g., second area 252 of FIG. 2C), and a folding area 353 (e.g., folding area 253 of FIG. 2C) between the first area 351 and the second area 352.

In an embodiment, the first housing 301 may be disposed to face the first area 351 of the display assembly 350 to support the first area 351. The second housing 302 may be disposed to face the second area 352 of the display assembly 350 to support the second area 352.

In an embodiment, the hinge unit 370 may be disposed between the first housing 301 and the second housing 302 to connect the first housing 301 to the second housing 302. For example, a hinge structure of the electronic device 300 may include a plurality of hinge units 370a and 370b. The hinge units 370a and 370b may be disposed spaced apart on both sides of the folding axis A (e.g., the Y-axis direction).

For example, as illustrated in FIG. 3A, two hinge units 370a and 370b may be respectively disposed at both ends (e.g., an end in the +Y-direction and an end in the -Y-direction) of the electronic device 300 along the folding axis A. However, the number and arrangement of the hinge units 370 are not limited to the foregoing description.

In an embodiment, the hinge unit 370 may perform folding or unfolding of the electronic device 300. The hinge unit 370 may operate between a folded state, in which the first area 351 and the second area 352 face each other, and an unfolded state, in which the first and second areas do not face each other. The hinge unit 370 may generate a force to maintain a specific folded state of the electronic device 300.

For example, when the electronic device 300 is in a folded state, the hinge unit 370 may generate a force (e.g., a close detent force) to maintain the folded state of the electronic device 300.

For example, when the electronic device 300 is in an unfolded state, the hinge unit 370 may generate a force (e.g., an open detent force) to maintain the unfolded state of the electronic device 300.

For example, when the electronic device 300 is in an intermediate state, the hinge unit 370 may generate a force (e.g., a free stop force) to maintain the intermediate state of the electronic device 300.

In an embodiment, the wing plate 400 may support the display assembly 350. The wing plate 400 may be disposed between the hinge unit 370 and the display assembly 350. The wing plate 400 may prevent the display assembly 350 from sagging under its own weight. Alternatively, the wing plate 400 may bear its own weight and/or an external force applied to the display assembly 350 to prevent damage to the display assembly 350.

In an embodiment, the wing plate 400 may be provided as a pair. For example, the wing plate 400 may include a first wing plate 400a and a second wing plate 400b. The first wing plate 400a may support the first area 351 of the display assembly 350, and the second wing plate 400b may support the second area 352 of the display assembly 350.

In an embodiment, the wing plate 400 may be fixed to the hinge unit 370 via a fixing member 390. The wing plate 400 may move in association with the operation of the hinge unit 370 and may assist a folding operation of the foldable housing 310 and/or the display assembly 350.

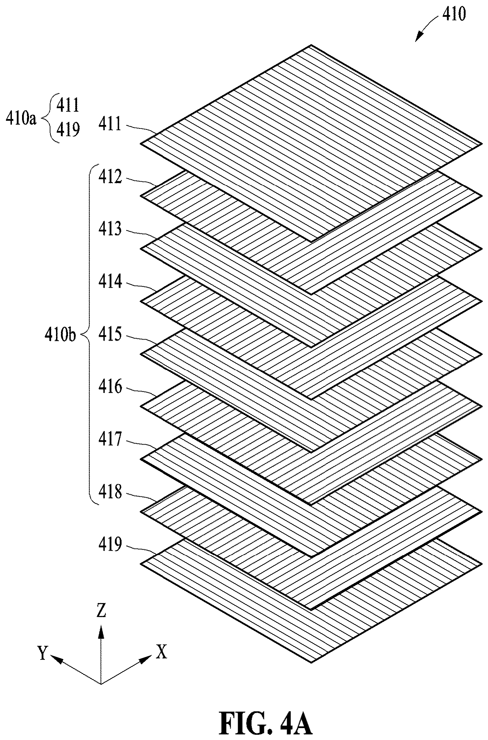

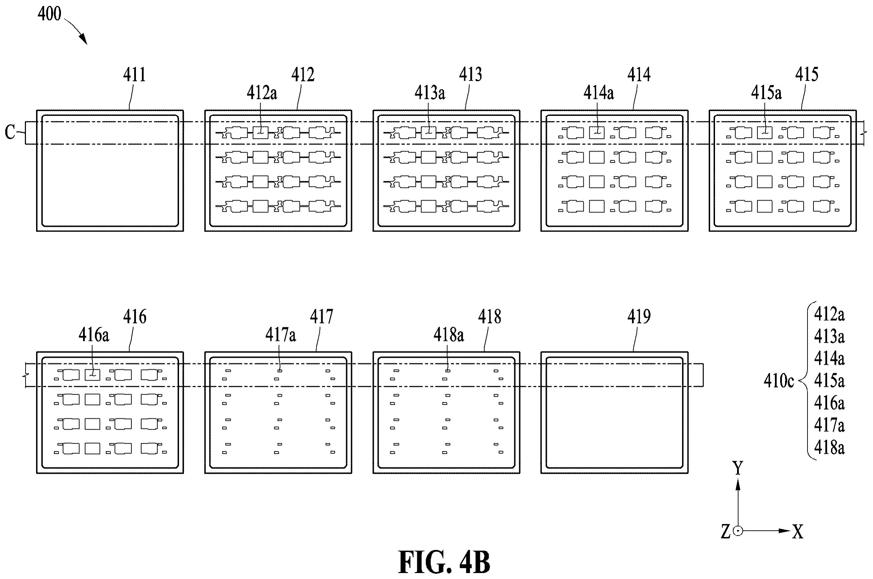

FIG. 4A is an exploded perspective view of a plurality of sheets 410 according to an embodiment, and FIG. 4B is a plan view of the plurality of sheets 410 according to an embodiment.

Referring to FIGS. 4A and 4B, a wing plate (e.g., the wing plate 400 of FIGS. 3A, 3B, and 3C) according to an embodiment may be formed by laminating the plurality of sheets 410.

The plurality of sheets 410 illustrated in FIGS. 4A and 4B are examples of raw materials or a state before machining used to form the wing plate 400. The size, shape, structure, arrangement, number, and material of the plurality of sheets 410 used to form the wing plate 400 in an embodiment of the present disclosure are not limited thereto.

Hereinafter, referring to the drawings, the plurality of sheets 410 and the wing plate 400 are described based on the plurality of sheets 410 having a uniform thickness and including nine sheets. However, this is merely illustrative, and the number, structure, shape, material, or thickness of the plurality of sheets 410 to be implemented are not limited thereto. For example, at least one sheet may have a thickness greater or smaller than that of the other sheets.

Hereinafter, any repeated description overlapping with the above description is omitted, and it is obvious that, in the wing plate 400 and an electronic device including the same (e.g., the electronic device 101 of FIG. 1, the electronic device 200 of FIGS. 2A, 2B, 2C, and 2D, or the electronic device 300 of FIGS. 3A, 3B, and 3C), a portion of the configuration and structure may be replaced, added, or omitted within a scope easily understandable by one of ordinary skill in the art with reference to the following drawings and descriptions. In addition, at least one component or feature of the embodiments described above may be combined with the wing plate 400 and the electronic device 300 including the wing plate 400 unless technically and clearly infeasible.

In an embodiment, the plurality of sheets 410 may include an outer sheet 410a and an inner sheet 410b, and may include, for example, a plurality of outer sheets 410a and at least one inner sheet 410b.

In an embodiment, the outer sheet 410a may be a sheet disposed outermost with respect to the center of the wing plate 400, or may be a sheet visually exposed to the outside of the wing plate 400. The inner sheet 410b may be a sheet disposed on an inner side of the outer sheet 410a, and may be a sheet not visually exposed to the outside of the wing plate 400 or only partially exposed.

In an embodiment, the plurality of outer sheets 410a may include a first outer sheet 411 and a second outer sheet 419. The first outer sheet 411 and the second outer sheet 419 may face in opposite directions.

For example, in a state (e.g., the state of FIG. 3C) in which the wing plate 400 is assembled to the electronic device 300, the first outer sheet 411 may be a sheet facing a display (e.g., the display assembly 350 of FIG. 3C). In addition, for example, in a state (e.g., the state of FIG. 3C) in which the wing plate 400 is assembled to the electronic device 300, the second outer sheet 419 may be a sheet facing a hinge unit (e.g., the hinge unit 370 of FIG. 3C).

In an embodiment, the first outer sheet 411 may have a center-line average (CLA) surface roughness in a range of 1.0 Ra to 5.0 Ra. Since the first outer sheet 411 faces the display assembly 350, bonding strength for coupling to other components (e.g., a tape) disposed on a front surface of the wing plate 400 may be required. A physical, optical, or chemical surface treatment (e.g., sand blasting) may be performed on the first outer sheet 411 to improve surface bonding strength.

For example, if the surface roughness of the first outer sheet 411 is greater than 5.0 Ra, a synthetic resin surface which protects carbon fibers of the plurality of sheets 410 may be damaged, and the carbon fibers may be exposed to the outside. The carbon fibers may then be damaged or may come into contact with other components, which may cause a short circuit.

For example, if the surface roughness of the first outer sheet 411 is less than 1.0 Ra, the surface bonding strength for coupling the wing plate 400 to other components may be reduced.

In an embodiment of the present disclosure, the first outer sheet 411 may have a CLA surface roughness in a range of 1.0 Ra to 5.0 Ra, thereby preventing carbon fibers of the plurality of sheets 410 from being exposed to the outside and thereby providing surface bonding strength.

In an embodiment, the inner sheet 410b may be provided as a plurality of sheets, and may include, for example, a total of seven sheets. The inner sheet 410b may include at least some of a first inner sheet 412, a second inner sheet 413, a third inner sheet 414, a fourth inner sheet 415, a fifth inner sheet 416, a sixth inner sheet 417, and a seventh inner sheet 418. The first inner sheet 412, the second inner sheet 413, the third inner sheet 414, the fourth inner sheet 415, the fifth inner sheet 416, the sixth inner sheet 417, and the seventh inner sheet 418 may be sequentially disposed and laminated between the first outer sheet 411 and the second outer sheet 419.

In an embodiment, each of the plurality of sheets 410 may be oriented in a single direction and may be formed of unidirectional (UD) fibers having a relatively higher stiffness in that direction than in other directions. UD fibers may refer to unidirectional fibers or fibers oriented in a single direction.

In an embodiment of the present disclosure, the wing plate 400 formed of a plurality of UD fiber sheets may be relatively light in weight, may be easy to machine, and may easily implement a target shape compared to a case formed of a metal material.

In addition, in an embodiment of the present disclosure, the wing plate 400 having a laminated structure of the plurality of sheets 410 may be advantageous for forming the wing plate 400 with a relatively small thickness, and may facilitate thickness control.

In an embodiment, any one of the plurality of sheets 410 may be oriented in a direction different from that of other adjacent sheets laminated among the plurality of sheets 410. If the directions in which each of the plurality of sheets 410 is oriented are different, the directions of higher rigidity of the respective sheets may also be different. Accordingly, the wing plate 400 formed by laminating the plurality of sheets 410 may provide high rigidity in a plurality of directions.

In an embodiment, any one of the plurality of sheets 410 may be oriented mutually perpendicular to an adjacent sheet laminated among the plurality of sheets 410. For example, as illustrated in FIG. 4A, the first outer sheet 411, the second inner sheet 413, the fourth inner sheet 415, the sixth inner sheet 417, and the second outer sheet 419 may be oriented parallel to the Y-axis. In addition, for example, the first inner sheet 412, the third inner sheet 414, the fifth inner sheet 416, and the seventh inner sheet 418 may be oriented parallel to the X-axis.

In an embodiment of the present disclosure, since the directions in which each of the plurality of sheets 410 is oriented differ from each other or are perpendicular to each other, the wing plate 400 may provide high rigidity in transverse and longitudinal directions, may achieve uniform tensile strength in the transverse and longitudinal directions, and may provide stable durability and rigidity.

In an embodiment, the plurality of sheets 410 may be prepreg sheets. For example, each of the plurality of sheets 410 may be manufactured by impregnating carbon fibers oriented in a unidirectional manner with a liquid synthetic resin (e.g., epoxy), and the wing plate 400 may be formed by thermally processing the laminated plurality of sheets 410.

In an embodiment of the present disclosure, the wing plate 400 including a plurality of prepreg sheets formed of UD fibers may have little to no unevenness on its surface compared to a general woven fabric, and may form a smoother surface with reduced roughness, thereby being advantageous for managing surface smoothness and roughness (e.g., a surface unevenness ratio) of the wing plate 400.

For example, if the wing plate 400 has many uneven structures and thus has high surface roughness, the uneven structures of the wing plate 400 may press the display assembly 350 and degrade image quality. In an embodiment of the present disclosure, the wing plate 400 including a plurality of prepreg sheets formed of UD fibers may reduce uneven structures and reduce surface roughness, thereby improving performance of the display assembly 350 of the electronic device 300.

In an embodiment, each of the plurality of sheets 410 may be formed of any one of carbon fiber, glass fiber, or aramid fiber. Alternatively, each of the plurality of sheets 410 may be formed of a blended fabric including at least two of carbon fiber, glass fiber, and aramid fiber. The material of the plurality of sheets 410 may be selected based on properties, production cost, and/or performance required for the wing plate 400.

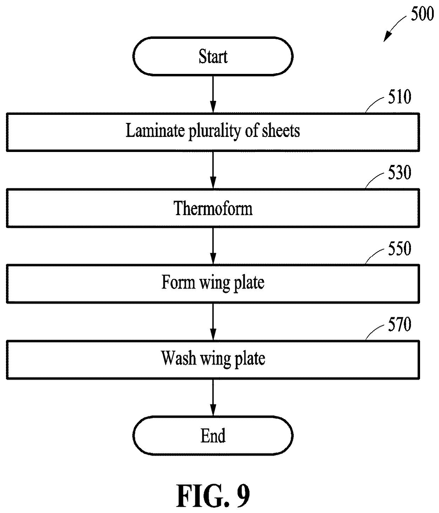

In an embodiment, the plurality of sheets 410 may be formed of fiber sheets and a liquid synthetic resin. For example, each of the plurality of sheets 410 may be formed by impregnating a plurality of fiber sheets used as raw materials with a liquid synthetic resin. The liquid synthetic resin may have a content of 30 percent (%) to 60% by weight based on the weight of the plurality of fiber sheets. As described below with reference to FIG. 9, during thermoforming of the plurality of sheets 410, the liquid synthetic resin may be cured, thereby bonding the plurality of fiber sheets together to form a laminated wing plate 400.

In an embodiment, the inner sheet 410b may include a punched hole 410c formed in at least a portion of the sheet. The punched hole 410c may define a structure and a step difference in height of the wing plate 400. When a portion of the inner sheet 410b is formed as an opening, the wing plate 400 including the inner sheet 410b may have a step formed in that portion, thereby implementing a three-dimensional structure and a stepped shape of the wing plate 400.

For example, as illustrated in FIG. 4B, the first inner sheet 412 may include a first punched hole 412a, the second inner sheet 413 may include a second punched hole 413a, the third inner sheet 414 may include a third punched hole 414a, the fourth inner sheet 415 may include a fourth punched hole 415a, the fifth inner sheet 416 may include a fifth punched hole 416a, the sixth inner sheet 417 may include a sixth punched hole 417a, and/or the seventh inner sheet 418 may include a seventh punched hole 418a.

In an embodiment, the components included within area C of FIG. 4B may form a single wing plate 400. The plurality of sheets 410 may be laminated, thermoformed, and cut and/or punched. Accordingly, the plurality of sheets 410 in area C may be laminated to form a single wing plate 400.

In an embodiment, the positions, shapes, and sizes of at least some of the plurality of punched holes 410c may be mutually different. By designing the shape and size of the plurality of punched holes 410c, the plurality of sheets 410 may form the intricate structure of the wing plate 400.

In an embodiment, the first outer sheet 411 and/or the second outer sheet 419 may be continuous across the entire area of the wing plate 400. Alternatively, the first outer sheet 411 and/or the second outer sheet 419 may not include any punched hole 410c or any opening.

For example, when a punched hole 410c is formed in the first outer sheet 411 and/or the second outer sheet 419, fibers may gather at an edge of the punched hole 410c, the edge may protrude and be visually emphasized, or a deviation in step height may occur.

In an embodiment of the present disclosure, the first outer sheet 411 and/or the second outer sheet 419 may be continuous across the entire area of the wing plate 400, thereby improving surface smoothness and roughness of the wing plate 400 and providing an improved surface quality of the product.

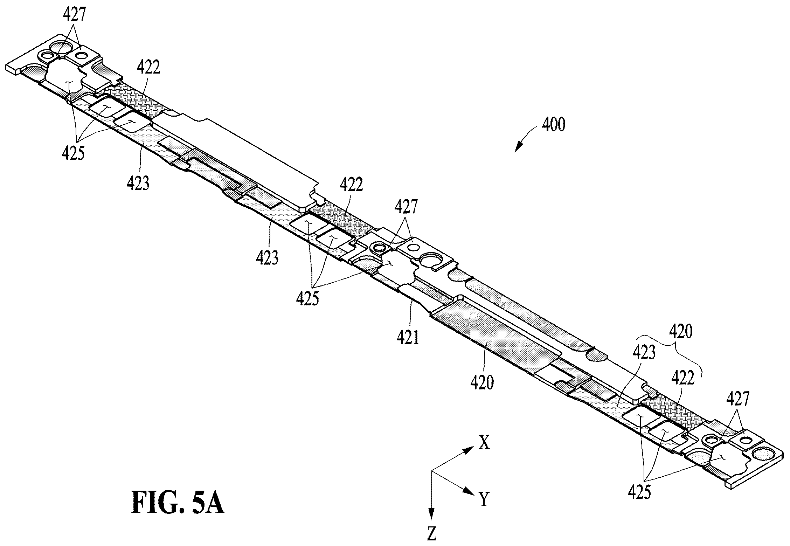

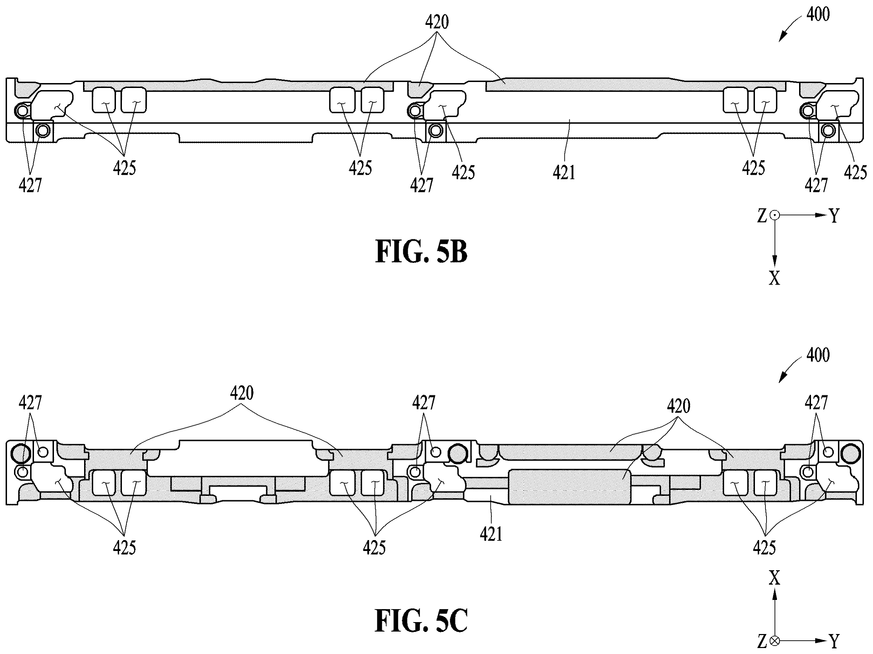

FIG. 5A is a perspective view of the wing plate 400 according to an embodiment, FIG. 5B is a plan view of the wing plate 400 according to an embodiment, and FIG. 5C is a rear view of the wing plate 400 according to an embodiment.

Specifically, FIGS. 5B and 5C are a plan view and a rear view illustrating in an emphasized manner the stepped structure of the wing plate 400 of FIG. 5A.

Specifically, FIGS. 5B and 5C are a plan view and a rear view illustrating the stepped structure of the wing plate 400 of FIG. 5A in an emphasized manner.

Hereinafter, the description provided above is not repeated, and it is apparent that, with reference to the following drawings and descriptions, at least a portion of the configuration and structure of the wing plate 400 may be replaced, added, or omitted within a scope easily understandable by one of ordinary skill in the art. In addition, at least one component or feature of the embodiments described above may be combined with the wing plate 400 unless this is technically and clearly infeasible.

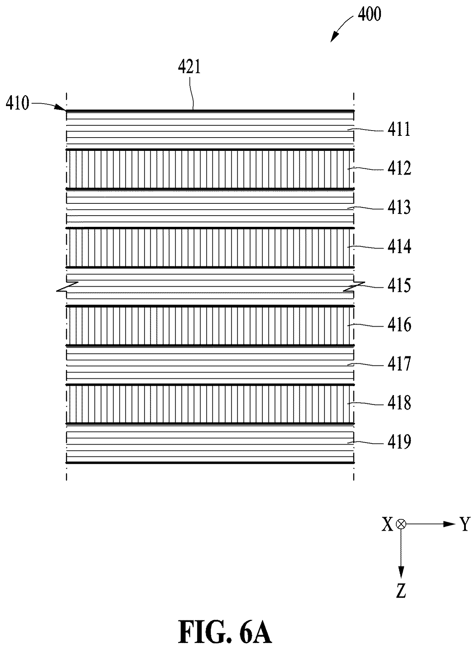

In an embodiment, the wing plate 400 may include a reference area 421. The reference area 421 may be any area in which no steps are formed. Alternatively, as illustrated in FIG. 6A to be described below, the reference area 421 may be an area in which no punched hole (e.g., the punched hole 410c of FIG. 4B) is formed.

In an embodiment, a stepped area 420 may be an area of the wing plate 400 having a thickness different from that of other areas (e.g., the reference area 421). For example, as illustrated in FIGS. 5B and 5C, the stepped area 420 may be an area that is lower in height or thinner than the reference area 421.

In an embodiment, the wing plate 400 may include a plurality of stepped areas 420. Alternatively, the wing plate 400 may include the plurality of stepped areas 420 with different thicknesses.

In an embodiment, the plurality of stepped areas 420 may include a first stepped area 422 and a second stepped area 423 which has a thickness smaller than that of the first stepped area 422. For example, the first stepped area 422 may be an area in which the stepped area 420 is formed on the back surface of the wing plate 400 and not formed on the front surface, and the second stepped area 423 may be an area in which the stepped area 420 is formed on both the back surface and the front surface of the wing plate 400. Alternatively, the second stepped area 423 may be an area with fewer laminated sheets (e.g., the plurality of sheets 410 of FIGS. 4A and 4B) than the first stepped area 422.

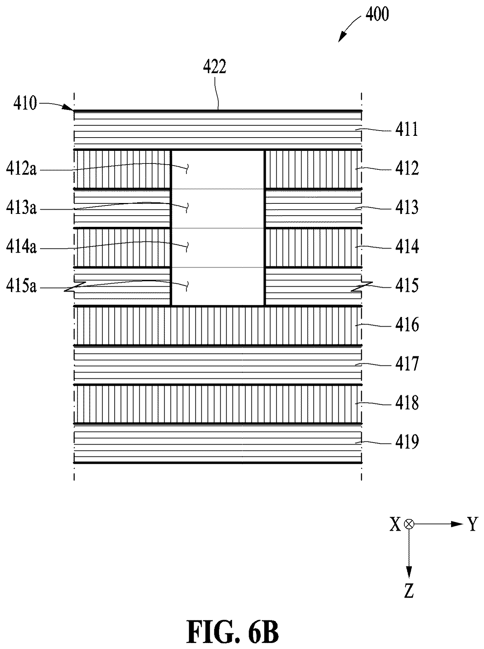

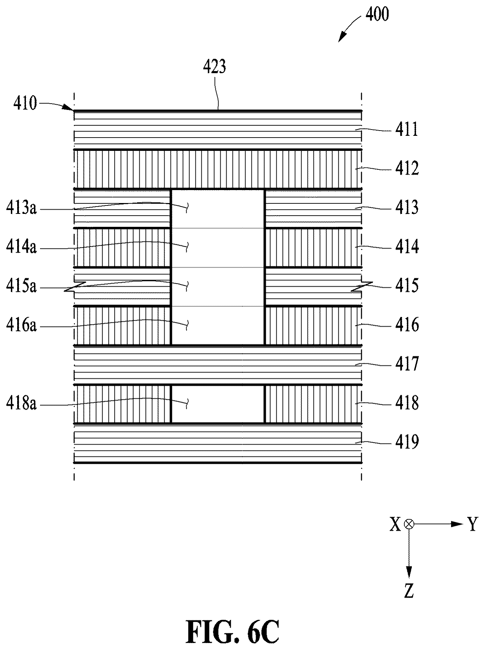

However, this is merely illustrative, and the structures and thicknesses of the plurality of stepped areas 420 are not limited thereto. For example, the first stepped area 422 and the second stepped area 423 may be two areas having different heights relative to the reference area 421 on the same side of the wing plate 400. Exemplary structures of the reference area 421, the first stepped area 422, and the second stepped area 423 are described with reference to FIGS. 6A, 6B, and 6C.

In an embodiment of the present disclosure, the stepped area 420 may reduce or eliminate interference or contact between the wing plate 400 and a hinge unit (e.g., the hinge unit 370 of FIGS. 3A, 3B, and 3C) and/or a display (e.g., the display assembly 350 of FIGS. 3A, 3B, and 3C). Alternatively, the stepped area 420 may be a structure to which a fixing member (e.g., the fixing member 390 of FIG. 3C) is fastened.

In an embodiment, the open area 425 may be an area which is open through the wing plate 400 from the front surface to the rear surface. The open area 425 may be an area through which at least a portion of the components of the hinge unit 370 pass, or may be an area to which the fixing member 390 is fastened. Alternatively, the open area 425 may be an area for reducing the weight of the wing plate 400 and may prevent or reduce interference with other components of the wing plate 400. After thermoforming of the wing plate 400, the open area 425 may be formed by perforating through a cutting process or computer numerical control (CNC) machining.

In an embodiment, the protruding area 427 may be an area of the wing plate 400 (e.g., the reference area 421) which protrudes, relative to an adjacent area, toward the front side (e.g., in the +Z direction or toward the display assembly 350) or toward the rear side (e.g., in the -Z direction or toward the hinge unit 370). The protruding area 427 may be an area to which the fixing member 390 for fixing the wing plate 400 to the hinge unit 370 or the foldable housing 310 is fastened.

FIG. 6A is a cross-sectional view of a portion of the wing plate 400 according to an embodiment, FIG. 6B is a cross-sectional view of a portion of the wing plate 400 according to an embodiment, and FIG. 6C is a cross-sectional view of a portion of the wing plate 400 according to an embodiment.

Specifically, FIGS. 6A, 6B, and 6C are cross-sectional views illustrating the laminated structure of the reference area 421, the first stepped area 422, and the second stepped area 423 in FIG. 5A. For ease of understanding, FIGS. 6A, 6B, and 6C may schematically illustrate a state before thermal processing or compression of the plurality of sheets 410. A plurality of punched holes (e.g., the punched holes 410c of FIG. 4B) of FIGS. 6A, 6B, and 6C may be subsequently thermally processed and filled by adjacent sheets, thereby forming a step in the corresponding area.

Referring to FIGS. 6A, 6B, and 6C, the wing plate 400 according to an embodiment may have different numbers of sheets 410 laminated in a plurality of areas (e.g., the reference area 421, the first stepped area 422, and the second stepped area 423).

Referring to FIG. 6A, in an embodiment, the reference area 421 of the wing plate 400 may be an area in which all of the plurality of sheets 410 are laminated. Alternatively, the reference area 421 may be any other area that is adjacent to the first stepped area 422 or the second stepped area 423. Alternatively, the reference area 421 of the wing plate 400 may be an area in which no punched hole (e.g., the punched hole 410c of FIG. 4B) is formed in a plurality of sheets 410.

However, the reference area 421 of FIG. 6A is merely illustrative, and the reference area 421 may be defined for comparison with the first stepped area 422 or the second stepped area 423. For example, the reference area 421 may be an area having a thickness greater than the first stepped area 422 or the second stepped area 423. Alternatively, the reference area 421 may be an area occupying a major portion of the wing plate 400.

Referring to FIGS. 6B and 6C, in an embodiment, different numbers of sheets 410 may be laminated in the first stepped area 422 and the second stepped area 423 compared with the reference area 421. For example, in the wing plate 400, the stepped area 420 having a thickness smaller than that of other areas may have fewer sheets 410 laminated compared with the other areas.

In an embodiment, referring to FIG. 6B, at least some (e.g., punched holes 412a, 413a, 414a, and 415a) of the plurality of punched holes 410c may be formed in the plurality of sheets 410 in the first stepped area 422. For example, the first stepped area 422 may be an area in which the first punched hole 412a, the second punched hole 413a, the third punched hole 414a, and the fourth punched hole 415a are formed.

In an embodiment, the first inner sheet 412, the second inner sheet 413, the third inner sheet 414, and the fourth inner sheet 415, in which at least some (e.g., punched holes 412a, 413a, 414a, and 415a) of the plurality of punched holes 410c are formed, may not be laminated in the first stepped area 422. Accordingly, the first stepped area 422 may include the first outer sheet 411, the fifth inner sheet 416, the sixth inner sheet 417, the seventh inner sheet 418, and the second outer sheet 419.

In an embodiment, referring to FIG. 6C, at least some (e.g., punched holes 413a, 414a, 415a, 416a, and 418a) of the plurality of punched holes 410c may be formed in the plurality of sheets 410 in the second stepped area 423. For example, the second stepped area 423 may be an area in which the second punched hole 413a, the third punched hole 414a, the fourth punched hole 415a, the fifth punched hole 416a, and the seventh punched hole 418a are formed.

In an embodiment, the second inner sheet 413, the third inner sheet 414, the fourth inner sheet 415, the fifth inner sheet 416, and the seventh inner sheet 418, in which at least some (e.g., punched holes 413a, 414a, 415a, 416a, and 418a) of the plurality of punched holes 410c are formed, may not be laminated in the second stepped area 423. Accordingly, the second stepped area 423 may include the first outer sheet 411, the first inner sheet 412, the sixth inner sheet 417, and the second outer sheet 419.

In an embodiment, in an area in which fewer sheets 410 are laminated, the wing plate 400 may be thinner and a relative step may be formed. For example, in the second stepped area 423 having a thickness smaller than that of the first stepped area 422, fewer sheets 410 may be laminated than in the first stepped area 422. Referring to FIGS. 6B and 6C, the first stepped area 422 may include a total of five sheets 410, and the second stepped area 423 may include a total of four sheets 410. However, this is merely illustrative, and the number and arrangement of the plurality of sheets 410 forming the stepped area 420 are not limited thereto and may be implemented in various ways.

In an embodiment, the stepped area 420 may be formed through at least one punched hole 410c formed in each of the respective sheets 410 of the wing plate 400. If a cutting process or CNC machining is performed on the wing plate 400 to form the stepped area 420, the structural continuity of the wing plate 400 may be compromised, its rigidity and durability may decrease, and burrs may be generated. In addition, precise control of the height of the wing plate 400 may be limited, expensive cutting equipment may be required, or errors may occur during the cutting process.

According to an embodiment of the present disclosure, the stepped area 420 may be easily and simply formed by providing punched holes 410c in the plurality of sheets 410, a precise step may be achieved at a target position, and the formation of burrs may be reduced or suppressed. In addition, according to an embodiment of the present disclosure, the wing plate 400 may simplify machining, achieve cost efficiency in manufacturing, and reduce or prevent degradation of its durability and rigidity.

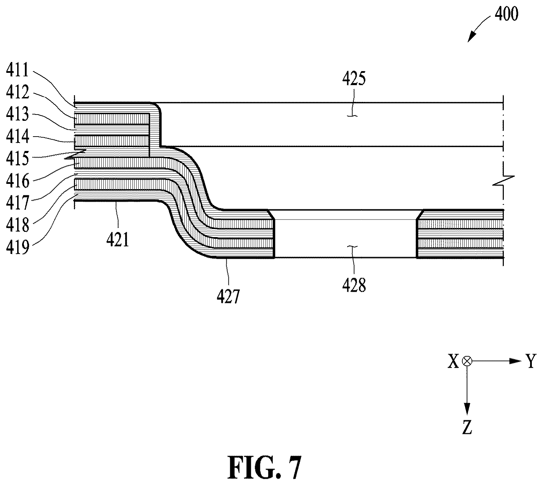

FIG. 7 is a cross-sectional view of a portion of the wing plate 400 according to an embodiment.

Referring to FIG. 7, the protruding area 427 according to an embodiment may include the plurality of sheets 410, at least some of which extend continuously from another area.

In an embodiment, the protruding area 427 may be an area protruding toward the front (e.g., in the +Z direction) or toward the back (e.g., in the -Z direction) relative to another adjacent area (e.g., the reference area 421) of the wing plate 400. A fastening hole 428 may be provided at the center of the protruding area 427. A fixing member (e.g., the fixing member 390 of FIG. 3C) may be inserted through the fastening hole 428 for fixing the wing plate 400 to another structure. After thermoforming of the wing plate 400, the fastening hole 428 may be perforated through a cutting process or CNC machining.

In an embodiment, the protruding area 427 may include at least some of the plurality of sheets 410 extending continuously from another adjacent area of the wing plate 400. For example, as illustrated in FIG. 7, the protruding area 427 may include the first outer sheet 411, the fifth inner sheet 416, the sixth inner sheet 417, the seventh inner sheet 418, and the second outer sheet 419, which are continuous from the reference area 421.

In an embodiment, since the plurality of sheets 410 extend continuously from another adjacent area into the protruding area 427, the wing plate 400 may reduce or prevent degradation of rigidity and durability in the protruding area 427.

In an embodiment, if a cutting process, CNC machining, and/or a thermal process is performed on the wing plate 400 to form the protruding area 427, the structural continuity of the wing plate 400 may be compromised, its durability may be degraded, and burrs may be generated. In addition, precise control of the height of the wing plate 400 may be limited, expensive cutting equipment may be required, or errors may occur during the cutting process. In addition, the protruding area 427 may be susceptible to damage due to torque and pressure applied by the fixing member 390 during fastening of the fixing member 390.

According to an embodiment of the present disclosure, the wing plate 400 may maintain continuity of at least some of the plurality of sheets 410 to form the protruding area 427, and may reduce or suppress the formation of burrs. In addition, the wing plate 400 may simplify machining, achieve cost efficiency in manufacturing, and reduce or prevent degradation of durability and rigidity. In addition, the wing plate 400 may reduce or prevent damage to the protruding area 427 during fastening of the fixing member 390.

In an embodiment, the protruding area 427 may be included as part of the stepped area (e.g., the stepped area 420 of FIGS. 5A, 5B, and 5C). As illustrated in FIG. 7, the protruding area 427 may have a thickness smaller than that of another adjacent area (e.g., the reference area 421) and a different number of laminated sheets 410.

For example, in a transition from the reference area 421 to the protruding area 427, the first inner sheet 412, the second inner sheet 413, the third inner sheet 414, and the fourth inner sheet 415 may be omitted through punched holes (e.g., the punched holes 410c in FIG. 4B). The first outer sheet 411, the fifth inner sheet 416, the sixth inner sheet 417, the seventh inner sheet 418, and the second outer sheet 419 may form the protruding area 427.

In an embodiment, when the number of sheets 410 forming the protruding area 427 is reduced, a step may be formed in the protruding area 427, and the protruding area 427 may be easily and simply formed.

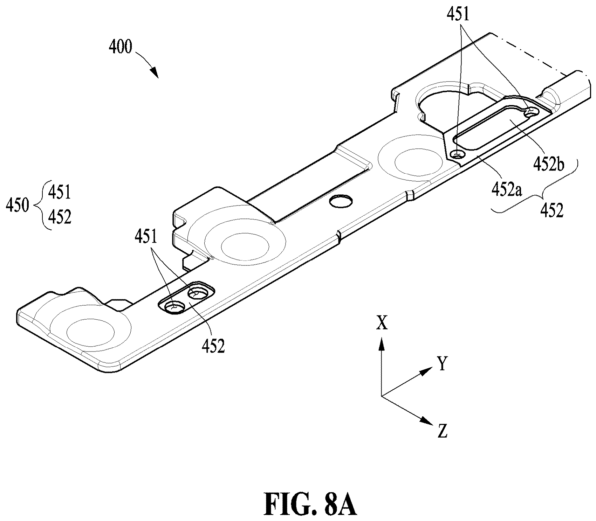

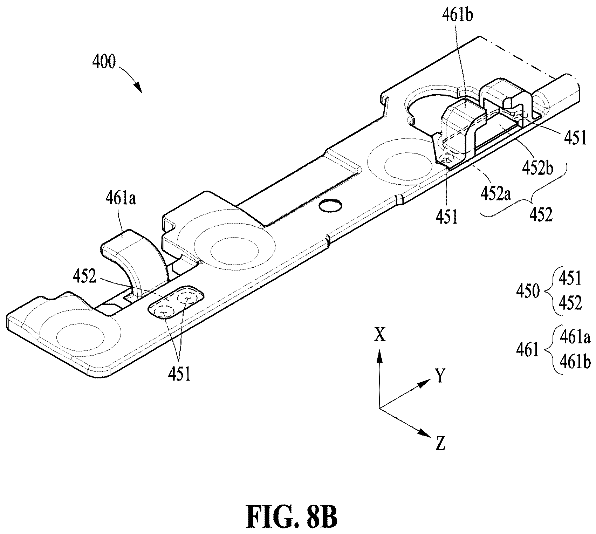

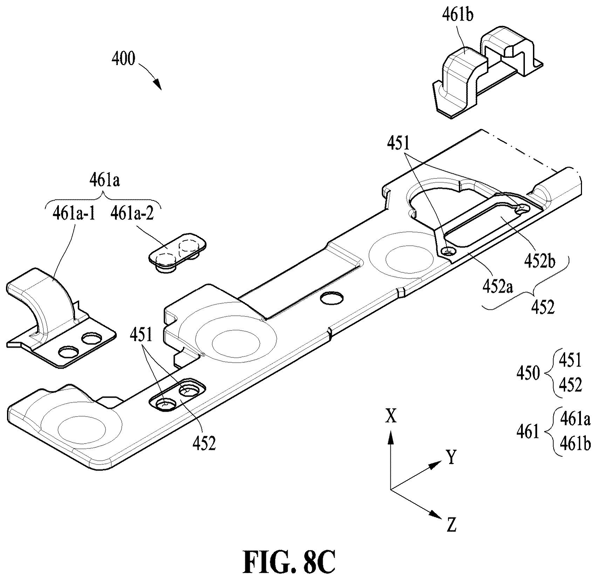

FIG. 8A is a perspective view of the wing plate 400 according to an embodiment, FIG. 8B is a perspective view of the wing plate 400 and a coupling member 461 according to an embodiment, and FIG. 8C is an exploded perspective view of the wing plate 400 and the coupling member 461 according to an embodiment.

Referring to FIGS. 8A, 8B and 8C, the wing plate 400 according to an embodiment may include a coupling area 450 and the coupling member 461.

Hereinafter, the description provided above is not repeated, and it is apparent that, with reference to the following drawings and descriptions, at least a portion of the configuration and structure of the wing plate 400 may be replaced, added, or omitted within a scope easily understandable by one of ordinary skill in the art. In addition, at least one component or feature of the embodiments described above may be combined with the wing plate 400 unless this is technically and clearly infeasible.

In an embodiment, the coupling area 450 may be an area having a thickness different from that of adjacent areas of the wing plate 400. For example, the coupling area 450 may be an example of a stepped area (e.g., the stepped area 420 of FIGS. 5A, 5B, and 5C) and/or an open area (e.g., the open area 425 of FIGS. 5A, 5B, and 5C).

In an embodiment, the coupling member 461 may be coupled to the coupling area 450. The coupling member 461 may be coupled to the wing plate 400, thereby forming a countergradient structure or an undercut structure. Since the wing plate 400 formed of the plurality of sheets 410 may have limitations in forming a countergradient or undercut structure, a separate coupling member 461 may be coupled to the wing plate 400, thereby allowing various structures and shapes to be included without limitation.

In an embodiment, referring to FIG. 8A, the coupling area 450 may include at least one of a first fastening structure 451 and a second fastening structure 452. The first fastening structure 451 and the second fastening structure 452 may fix and/or support the coupling member 461.

In an embodiment, the first fastening structure 451 may be an opening extending from one surface to the opposite surface of the wing plate 400, to allow the coupling member 461 to pass therethrough. The second fastening structure 452 may be a step or groove formed inward from the outer circumferential surface of the wing plate 400, to seat the coupling member 461.

In an embodiment, referring to FIG. 8B, the wing plate 400 may include a plurality of coupling members 461, and the plurality of coupling members 461 may include a first coupling member 461a and a second coupling member 461b. The first coupling member 461a and the second coupling member 461b may have mutually different shapes.

In an embodiment, the coupling member 461 may be coupled to the wing plate 400 through insert injection molding. For example, the wing plate 400 may be disposed in a mold, and the coupling member 461 may be molded on the wing plate 400 by injecting a synthetic resin through insert injection molding. When using insert injection molding, the risk that the coupling member 461 is separated or detached from the coupling area 450 may be reduced or eliminated, and the coupling member 461 may be stably coupled to the wing plate 400.

In an embodiment, referring to FIG. 8C, the first coupling member 461a may be divided into a first coupling portion 461a-1 and a second coupling portion 461a-2. The first coupling portion 461a-1 and the second coupling portion 461a-2 are structures for being fixed through the first fastening structure 451 of the coupling area 450, and are disposed to face each other on both sides of the wing plate 400 and are mutually coupled and assembled on the wing plate 400. The first coupling portion 461a-1 and the second coupling portion 461a-2 may be mutually coupled in structure and/or adhesively bonded using a bonding material.

In an embodiment, the coupling member 461 may be separately injection-molded or manufactured from the wing plate 400, and may then be coupled and/or bonded to the coupling area 450 of the wing plate 400. For example, the coupling member 461 may be separately injection-molded or formed, and may have a shape corresponding to the first fastening structure 451 and the second fastening structure 452 of the wing plate 400. When the coupling member 461 is formed separately, its material may be variously selected, and various levels of rigidity or elasticity may be achieved.

For example, the coupling member 461 may be formed of a synthetic resin. For example, the coupling member 461 may be formed of at least one selected from the group consisting of polycarbonate (PC), glass fiber-reinforced polycarbonate, carbon fiber-reinforced polycarbonate, polyamide, glass fiber-reinforced polyamide, carbon fiber-reinforced polyamide, polyetheretherketone, glass fiber-reinforced polyetheretherketone, and carbon fiber-reinforced polyetheretherketone. The coupling member 461 may improve rigidity by being reinforced with glass fiber and carbon fiber, and the content is not particularly limited.

FIG. 9 is a flowchart of a manufacturing method 500 of the wing plate 400 according to an embodiment.

Referring to FIG. 9, the manufacturing method 500 of the wing plate 400 according to an embodiment may include at least some of a laminating operation 510 to laminate the plurality of sheets 410, a thermoforming operation 530, a forming operation 550 to form the wing plate 400, and a washing operation 570 to wash the wing plate 400.

Hereinafter, any repeated description overlapping with the above description is omitted, and the wing plate 400 to be manufactured by the manufacturing method 500 may be the above-described wing plate 400 or may be a different wing plate 400. In addition, in the wing plate 400 to be manufactured by the manufacturing method 500, it is obvious that a portion of the configurations and structures may be replaced, added, or omitted within a scope easily understandable by one of ordinary skill in the art with reference to the following drawings and descriptions. In addition, the wing plate 400 to be manufactured by the manufacturing method 500 may be combined with at least one component or feature of the embodiments described above unless this is technically and clearly infeasible.

In an embodiment, the laminating operation 510 to laminate the plurality of sheets 410 may be performed by laminating a plurality of fiber sheets in a prepreg state. The laminating operation 510 to laminate the plurality of sheets 410 may include removing release paper attached to the sheets in a prepreg state and sequentially seating the sheets on a jig.

In an embodiment, each of the plurality of sheets 410 may be oriented in a single direction and may be formed of UD fibers having a relatively higher stiffness in that direction than in other directions.

In an embodiment, the laminating operation 510 may include laminating the plurality of sheets 410 such that any one of the sheets is oriented in a direction different from an adjacent sheet (e.g., a vertical direction).

In an embodiment, the thermoforming operation 530 may include positioning the laminated sheets 410 in a mold and thermoforming the sheets. The plurality of sheets 410 may be formed by impregnating the sheets with a synthetic resin, and since the synthetic resin undergoes a curing reaction upon being exposed to a high temperature for a predetermined period of time, the plurality of sheets 410 may therefore be thermoformed.

For example, the thermoforming operation 530 may be performed at a temperature of 145 to 155 degrees Celsius, under a pressure of 180 to 200 bar, with a preheating time of 10 to 20 seconds, and with a molding time of about 400 seconds. Alternatively, the thermoforming operation 530 may be performed at a temperature of 150 to 180 degrees Celsius, with a molding time of 400 to 1800 seconds. For example, the thickness of the plurality of sheets 410 after being thermoformed may be 0.85 mm.

In an embodiment, the forming operation 550 to form the wing plate 400 may include cutting and/or punching the thermoformed sheets 410 to form the wing plate 400. The forming operation 550 to form the wing plate 400 may include machining the outer contour and opening shape of the product by rough machining and/or finish machining to form the product shape.

For example, the forming operation 550 to form the wing plate 400 may include CNC machining to cut the outer contour and opening structure of the wing plate 400 to a predetermined depth (e.g., 0.3 mm) to form the wing plate 400.

In an embodiment, the washing operation 570 to wash the wing plate 400 may remove fine carbon fibers generated in the forming operation 550 to form the wing plate 400, and may remove foreign substances on the surface of the wing plate 400.

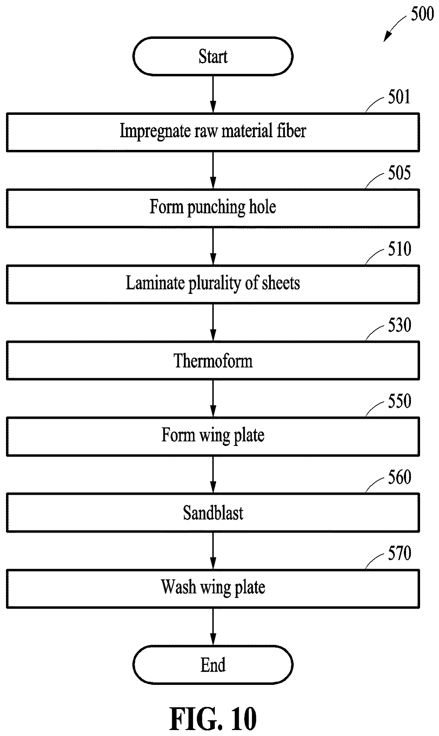

FIG. 10 is a flowchart of the manufacturing method 500 of the wing plate 400 according to an embodiment.

Referring to FIG. 10, the manufacturing method 500 of the wing plate 400 according to an embodiment may further include at least some of a raw material fiber impregnation operation 501, a punched hole forming operation 505 to form the punched hole 410c, and a sand blasting operation 560.

Hereinafter, any repeated description overlapping with the above description is omitted, and the wing plate 400 to be manufactured by the manufacturing method 500 may be the above-described wing plate 400 or may be a different wing plate 400. In addition, in the wing plate 400 to be manufactured by the manufacturing method 500, it is obvious that a portion of the configurations and structures may be replaced, added, or omitted within a scope easily understandable by one of ordinary skill in the art with reference to the following drawings and descriptions. In addition, the wing plate 400 to be manufactured by the manufacturing method 500 may be combined with at least one component or feature of the embodiments described above unless this is technically and clearly infeasible.

In an embodiment, the raw material fiber impregnation operation 501 and the punched hole forming operation 505 to form punched holes 410c may be performed before the laminating operation 510 to laminate the plurality of sheets 410. The raw material fiber impregnation operation 501 may form sheets in a prepreg state by impregnating each fiber sheet serving as a raw material for the plurality of sheets 410 with a liquid synthetic resin such as epoxy resin. The impregnated liquid synthetic resin may have a content of 30 to 60% by weight based on the weight of the plurality of fiber sheets.

In an embodiment, the punched hole forming operation 505 to form the punched hole 410c may form the punched hole 410c in at least some of the impregnated plurality of raw material fibers. The punched hole 410c may form a step of the wing plate 400. The positions, shapes, and sizes of the punched holes 410c in the plurality of sheets 410 may be mutually different. In the punched hole forming operation 505 to form the punched hole 410c, the two sheets laminated at the outermost layer among the plurality of sheets 410 may not be formed with the punched hole 410c.

In an embodiment, the sand blasting operation 560 may include performing a sand blasting process on at least one surface of the wing plate 400 before the washing operation 570 to wash the wing plate 400.

In an embodiment, since the wing plate 400 is required to undergo a plurality of processes, the surface of the wing plate 400 formed of a carbon composite material may have release agents and other contaminants remaining thereon. Release agents are chemicals used to prevent bonding between the wing plate 400 and a surface of another material. The release agents may interfere with bonding between an adhesive and the wing plate 400. Since the release agents are difficult to remove with alcohols and other organic solvents, and other contaminants remaining on the surface of the wing plate 400 reduce bonding strength between the wing plate 400 and other components, a sandblasting process may be performed to treat the surface of the wing plate 400 to improve surface bonding strength. In addition, a sandblasting process may remove fine carbon fiber burrs generated during the forming operation 550 to form the wing plate 400. Through a sandblasting process, at least one surface of the wing plate 400 may have a CLA surface roughness in a range of 1.0 Ra to 5.0 Ra.

Although not shown in the drawings, the manufacturing method 500 of the wing plate 400 may further include a forming operation (not shown) to form the coupling member 461.

In an embodiment, the forming operation (not shown) for forming the coupling member 461 may include insert-injection-molding a coupling member 461 made of a synthetic resin into a coupling area 450 provided in the wing plate 400, thereby forming a countergradient structure or an undercut structure in the wing plate 400. However, the forming operation (not shown) of the coupling member 461 is not limited thereto, and may include forming by assembling and/or bonding the coupling member 461 formed separately from the wing plate 400 to the wing plate 400.

According to an embodiment of the present disclosure, an electronic device 300 may include a display assembly 350 including a first area 351, a second area 352, and a folding area 353 between the first area 351 and the second area 352, a first housing 301 for supporting the first area 351, a second housing 302 for supporting the second area 352, a hinge unit 370 for connecting the first housing 301 and the second housing 302 and operating between a folded state in which the first area 351 and the second area 352 face each other and an unfolded state in which the first area 351 and the second area 352 do not face each other, and a wing plate 400 disposed between the hinge unit 370 and the display assembly 350 and for supporting the display assembly 350. In an embodiment, the wing plate 400 may be formed by laminating a plurality of sheets 410.

In an embodiment, each of the plurality of sheets 410 may be oriented in a single direction and may be formed of UD fibers having a relatively higher stiffness in that direction than in other directions.

In an embodiment, any one of the plurality of sheets 410 may be oriented in a direction different from that of other adjacent sheets laminated among the plurality of sheets 410.

In an embodiment, any one of the plurality of sheets 410 may be oriented mutually perpendicular to an adjacent sheet laminated among the plurality of sheets 410.

In an embodiment, the wing plate 400 may include a stepped area 420 having a thickness different from that of an adjacent area of the wing plate 400. In an embodiment, the number of the plurality of sheets 410 laminated in the stepped area 420 may be different from that of an adjacent area of the wing plate 400.

In an embodiment, the wing plate 400 may include a plurality of stepped areas 420. In an embodiment, the plurality of stepped areas 420 may include a first stepped area 422 and a second stepped area 423 having a thickness smaller than that of the first stepped area 422 and fewer sheets 410 laminated than in the first stepped area 422.

In an embodiment, the wing plate 400 may include a protruding area 427 protruding toward the display assembly 350 or the hinge unit 370 relative to an adjacent area of the wing plate 400. In an embodiment, the protruding area 427 may include at least some of the plurality of sheets 410 extending from another adjacent area of the wing plate 400.

In an embodiment, the plurality of sheets 410 may include a first outer sheet 411 facing the display assembly 350, a second outer sheet 419 disposed opposite to the first outer sheet 411 and facing the hinge unit 370, and an inner sheet 410b laminated between the first outer sheet 411 and the second outer sheet 419.

In an embodiment, the inner sheet 410b may include a punched hole 410c formed in at least a portion of the sheet.

In an embodiment, the first outer sheet 411 may be continuous across the entire area of the wing plate 400.

In an embodiment, the second outer sheet 419 may be continuous across the entire area of the wing plate 400.

In an embodiment, the first outer sheet 411 may have a CLA surface roughness in a range of 1.0 Ra to 5.0 Ra.

In an embodiment, the wing plate 400 may include a coupling area 450 having a thickness different from that of an adjacent area of the wing plate 400, and a coupling member 461 that is coupled to the coupling area 450.

In an embodiment, the coupling area 450 may include a first fastening structure 451 that is an opening extending from one surface to the opposite surface of the wing plate 400, to allow the coupling member 461 to pass therethrough.

In an embodiment, the coupling area 450 may include a second fastening structure 452 grooved inwardly from an outer surface of the wing plate 400 for seating the coupling member 461.

In an embodiment, each of the plurality of sheets 410 may be formed of any one of carbon fiber, glass fiber, or aramid fiber, or of a blended fabric including at least two of carbon fiber, glass fiber, and aramid fiber.

In an embodiment, the plurality of sheets 410 may be formed of a plurality of fiber sheets and a liquid synthetic resin, and the liquid synthetic resin may have a content of 30 to 60% by weight based on the weight of the plurality of fiber sheets.

In addition, a manufacturing method 500 of the wing plate 400 according to an embodiment of the present disclosure may include a laminating operation 510 to laminate the plurality of sheets 410, a thermoforming operation 530 to position the plurality of sheets 410 in a mold and thermoform the sheets, a forming operation 550 to cut the thermoformed plurality of sheets 410 to form the wing plate 400, and a washing operation 570 to wash the wing plate 400.

In an embodiment, the manufacturing method 500 of the wing plate 400 may further include a sand blasting operation 560 to perform a sand blasting process on at least one surface of the wing plate 400 before the washing operation 570 to wash the wing plate 400.

In an embodiment, the manufacturing method 500 of the wing plate 400 may further include, before the laminating operation 510 to laminate the plurality of sheets 410, the raw material fiber impregnation operation 501 and the punched hole forming operation 505 to form the punched hole 410c in at least some of the impregnated raw material fibers.

Although desirable embodiments are illustrated and described above, the present disclosure is not limited to said certain embodiments, various applications may surely be performed by those skilled in the art without deviating from what is claimed in the scope of claims, and such applications should not be understood separately from the technical idea or prospects herein.

## Claims

1. An electronic device (300) comprising:
a display assembly (350) comprising a first area (351), a second area (352), and a folding area (353) between the first area (351) and the second area (352);
a first housing (301) supporting the first area (351);
a second housing (302) supporting the second area (352);
a hinge unit (370) connecting the first housing (301) and the second housing (302) and operating between a folded state in which the first area (351) and the second area (352) face each other and an unfolded state in which the first area (351) and the second area (352) do not face each other; and
a wing plate (400) disposed between the hinge unit (370) and the display assembly (350) and supporting the display assembly (350),
wherein the wing plate (400) is formed by laminating a plurality of sheets (410).

2. The electronic device (300) of claim 1, wherein each of the plurality of sheets (410) is formed of unidirectional (UD) fiber oriented in a single direction and exhibiting higher rigidity in the single direction than in other directions.

3. The electronic device (300) of claim 1 or 2, wherein one of the plurality of sheets (410) is oriented in a direction different from that of an adjacent sheet laminated among the plurality of sheets (410).

4. The electronic device (300) of any one of claims 1 to 3, wherein one of the plurality of sheets (410) is oriented in a direction perpendicular to an adjacent sheet laminated among the plurality of sheets (410).

5. The electronic device (300) of any one of claims 1 to 4, wherein the wing plate (400) comprises a stepped area (420) having a thickness different from that of an adjacent area of the wing plate (400), and
a number of the plurality of sheets (410) laminated in the stepped area (420) is different from that in the adjacent area of the wing plate (400).

6. The electronic device (300) of any one of claims 1 to 5, wherein the wing plate (400) comprises a plurality of stepped areas (420), and
the plurality of stepped areas (420) comprises a first stepped area (422) and a second stepped area (423) having a thickness smaller than that of the first stepped area (422),
wherein a number of the plurality of sheets (410) laminated in the second stepped area (423) is less than that in the first stepped area (422).

7. The electronic device (300) of any one of claims 1 to 6, wherein the wing plate (400) comprises a protruding area (427) protruding toward the display assembly (350) or the hinge unit (370) relative to an adjacent area of the wing plate (400), and
the protruding area (427) is an area in which at least some of the plurality of sheets (410) extend from an adjacent area of the wing plate (400).

8. The electronic device (300) of any one of claims 1 to 7, wherein the plurality of sheets (410) comprises:
a first outer sheet (411) facing the display assembly (350);
a second outer sheet (419) provided in a direction opposite to the first outer sheet (411) and facing the hinge unit (370); and
an inner sheet (410b) laminated between the first outer sheet (411) and the second outer sheet (419).

9. The electronic device (300) of any one of claims 1 to 8, wherein the inner sheet (410b) comprises a punched hole (410c) provided in at least a portion thereof.

10. The electronic device (300) of any one of claims 1 to 9, wherein the first outer sheet (411) extends across an entire area of the wing plate (400).

11. The electronic device (300) of any one of claims 1 to 10, wherein the second outer sheet (419) extends across the entire area of the wing plate (400).

12. The electronic device (300) of any one of claims 1 to 11, wherein the first outer sheet (411) has a center-line average surface roughness in a range of 1.0 Ra to 5.0 Ra.

13. The electronic device (300) of any one of claims 1 to 12, wherein the wing plate (400) comprises:
a coupling area (450) having a thickness different from that of an adjacent area of the wing plate (400); and
a coupling member (461) coupled to the coupling area (450).

14. The electronic device (300) of any one of claims 1 to 13, wherein the coupling area (450) comprises a first fastening structure (451) that is open through the wing plate (400) from one surface to another surface, such that the coupling member (461) passes therethrough.

15. The electronic device (300) of any one of claims 1 to 14, wherein the coupling area (450) comprises a second fastening structure (452) that is grooved inward from an outer circumferential surface of the wing plate (400), such that the coupling member (461) is seated.
